# EUROPÄISCHE PATENTSCHRIFT

(11) **EP 2 761 052 B1**
(45) Veröffentlichungstag und Bekanntmachung des Hinweises auf die Patenterteilung: **31.07.2019**
(21) Anmeldenummer: 12784204.5
(22) Anmeldetag: 28.09.2012
(51) Int. Cl.: C23C 14/56, C23C 14/50

(54) **TRANSPORTEINRICHTUNG ZUM TRANSPORTIEREN MEHRERER SUBSTRATE IN DEN BEREICH EINER SUBSTRAT-BEHANDLUNGSEINRICHTUNG**
TRANSPORTING APPARATUS FOR TRANSPORTING A VARIETY OF SUBSTRATES INTO THE REGION OF A SUBSTRATE-TREATMENT APPARATUS
DISPOSITIF DE TRANSPORT DESTINÉ À TRANSPORTER PLUSIEURS SUBSTRATS DANS LA ZONE D'UN DISPOSITIF DE TRAITEMENT DE SUBSTRAT

(30) Priorität: 30.09.2011 DE 102011114593
(43) Veröffentlichungstag der Anmeldung: 06.08.2014
(73) Patentinhaber: Manz AG, 72768 Reutlingen (DE)
(72) Erfinder: RETTENBACHER, Peter, 60316 Frankfurt (DE); MERZ, Thomas, 63743 Aschaffenburg (DE); KASTL, Stefan, 63743 Aschaffenburg (DE)
(74) Vertreter: Weilnau, Carsten
(86) Internationale Anmeldenummer: PCT/EP2012/004092
(87) Internationale Veröffentlichungsnummer: WO 2013/045110

(56) Entgegenhaltungen:
- EP-A1- 1 536 454
- EP-A2- 0 449 227
- EP-A2- 0 905 275
- DE-C1- 19 806 282
- DE-C3- 2 454 544

## Beschreibung

### Technisches Gebiet

Die vorliegende Erfindung betrifft eine Transporteinrichtung zum gleichzeitigen Transportieren von zumindest zwei in oder an einer Behandlungseinrichtung zu behandelnden Substraten. Die zumindest zwei Substrate sind hierbei bezüglich einer gemeinsamen Achse drehbar gelagert, aber axial versetzt zueinander angeordnet.

### Hintergrund und Stand der Technik

Vorrichtungen zur Oberflächenbehandlung von Substraten, insbesondere zum Ätzen und Beschichten von Substratoberflächen sind im Stand der Technik hinlänglich bekannt. Unter einer Vielzahl gängiger Beschichtungsverfahren und -Vorrichtungen kommen beispielsweise chemische sowie physikalische Dampfabscheidungsverfahren (Chemical Vapour Deposition (CVD) oder Physical Vapour Deposition (PVD)), hierunter insbesondere plasmaunterstützte chemische Dampfabscheidungsverfahren, sogenannte PECVD-Verfahren, zum Einsatz.

Bei plasmaunterstützten chemischen Dampfabscheidungsverfahren werden ein oder mehrere Substrate in einer Vakuumkammer angeordnet, in welche unter Einhaltung vorgegebener Druck- und Temperaturparameter ein Reaktionsgas bzw. ein auf die Oberflächenbehandlung abgestimmtes Gasgemisch eingeleitet wird. Dieses kann durch Zufuhr und Beaufschlagung elektromagnetischer Energie zumindest teilweise in einen für die jeweilige Oberflächenbehandlung vorgesehenen Plasmazustand übergehen.

Typischerweise sind dem eigentlichen Oberflächen-Behandlungsprozess weitere Prozesse, wie zum Beispiel ein Aufheizen, ein Abkühlen sowie ein Ein- und/oder Ausschleusen des Substrats in bzw. aus einem Vakuumbereich vor- bzw. nachgelagert. Es erweist sich als zweckmäßig, die zu behandelnden Substrate mittels einer Transporteinrichtung sequenziell einzelnen Prozessstationen zuzuführen.

Es existieren unterschiedliche Ansätze zur Anordnung einzelner Prozessstationen sowie für die sich hieraus ergebenden Transportkonzepte. Beim Durchlaufverfahren werden die einzelnen Substrate zum Beispiel nacheinander, meist unter Beibehaltung ihrer Bewegungsrichtung durch die einzelnen, etwa linear aneinander angrenzenden Prozessstationen hindurch befördert. Beim sogenannten Batchbetrieb werden in ähnlicher Art und Weise jeweils mehrere Substrate paket- oder stapelweise den einzelnen Prozessstationen zugeführt. Der Durchlauf- als auch der Batchbetrieb erweisen sich insoweit als nachteilig, als dass zur Herstellung vorgegebener Vakuumbedingungen die jeweils vergleichsweise großen Volumina einzelner Prozessstationen auf ein vorgegebenes Druckniveau gebracht werden müssen.

Ferner ist aus der DE 24 54 544 C4 eine Vakuumbeschichtungsanlage zum Aufdampfen dünner Schichten auf Substrate bekannt, die eine Fördereinrichtung zum Transport der Substrate durch mehrere Kammern aufweist. Die Fördereinrichtung weist dabei mehrere, um eine gemeinsame Achse herum angeordnete und um diese Achse schwenkbare Rahmen für die Aufnahme der Substrate auf, wobei an wenigstens zwei Behandlungspositionen, nämlich einer Ein- und Austrittsposition und in einer Aufdampfposition ein solcher Rahmen selbst Teil einer Wand einer Behandlungskammer bildet.

Ferner ist in mindestens einer dieser Behandlungspositionen eine bewegliche Ventilplatte zum Absperren einer Stirnseite des ein Teil der Behandlungskammer bildenden Rahmens vorgesehen.

Die zum Abdichten unterschiedlicher Kammern vorgesehenen Ventilplatten sind hierbei an gegenüberliegenden Seiten eines Außengehäuses der Vakuumbeschichtungsanlage vorgesehen. Das Außengehäuse muss hierbei hinreichend stabil und verwindungssteif ausgelegt sein, um jeweils im Bereich der Behandlungskammer sowie der Ein- und Austrittskammern eine zur Betätigung der jeweiligen Ventilplatten ausreichende Gegenkraft bereitstellen zu können. Weiterhin ist aus der EP 1 536 454 A1 ein Vakuumsystem mit einer Schleuse bekannt, welches eine Prozesskammer und eine Transportkammer aufweist. In der Transportkammer ist dabei ein Hubschwenkarm-Substratträger zum Transport der Substrate von der Schleuse zur Prozesskammer und umgekehrt angeordnet.

Die EP 0 905 275 A2 beschreibt ferner eine Vorrichtung zum Beschichten eines scheibenförmigen Substrats mit Hilfe der Kathodenzerstäubung. Die DE 198 06 28 C1 offenbart eine Vorrichtung und ein Verfahren zum Belüften einer Vakuum-Bearbeitungskammer, wobei vor der Belüftung mindestens eine Öffnung in der Transportkammer, die mit einer Vakuumpumpe in Verbindung steht, durch Absenken eines Schwenkträgers für Werkstückträger mittels eines Deckels verschlossen wird. Ferner ist aus der EP 0 449 227 A2 eine Sputtervorrichtung zur Herstellung optischer Scheiben bekannt.

### Aufgabe

Demgegenüber liegt der vorliegenden Erfindung die Aufgabe zugrunde, eine verbesserte Transporteinrichtung sowie eine hiermit ausgestattete Vakuumbehandlungseinrichtung bereitzustellen, deren Transportkonzept eine verbesserte und für die Konzeption der Beschichtungsanlage optimierte Krafteinleitung sowie Kraftverteilung, insbesondere zum Abdichten einzelner Prozessstationen ermöglicht. Des Weiteren ist es Zielsetzung der Erfindung, ein hinsichtlich Transportlogistik verbessertes Transportkonzept für eine Vakuumbehandlungseinrichtung bereitzustellen, welches die Behandlungskapazität einzelner Prozessstationen besser und umfassend ausnutzen kann.

### Erfindung

Die der Erfindung zugrundeliegende Aufgabe wird mit einer Transporteinrichtung gemäß Patentanspruch 1, ferner mit einer Vakuumbehandlungseinrichtung gemäß Patentanspruch 11 gelöst, wobei vorteilhafte Ausgestaltungen der Erfindung jeweils Gegenstand abhängiger Patentansprüche sind.

Die erfindungsgemäße Transporteinrichtung ist zum gleichzeitigen Transportieren von zumindest zwei in oder an einer Vakuumbehandlungseinrichtung zu behandelnden Substraten ausgebildet. Hierfür weist sie, zumindest zwei bezüglich einer gemeinsamen Achse drehbar gelagerte, aber bezogen auf die Achse axial versetzt zueinander angeordnete Trägereinrichtungen auf. An jeder der Trägereinrichtungen ist zumindest jeweils ein zur Aufnahme zumindest eines oder mehrerer Substrate ausgebildeter Halterahmen angeordnet. Die beiden Trägereinrichtungen sind durch eine Drehbewegung um die gemeinsame Achse in den Bereich einer in Axialrichtung zwischen den beiden Trägereinrichtungen anordenbaren Behandlungseinheit überführbar. Die an den Halterahmen angeordneten Substrate sind hierdurch in jeweils zueinander gegenüberliegende Wirkungsbereiche der Behandlungseinheit überführbar und nach erfolgter Behandlung entlang derselben oder einer entgegen gerichteten Drehbewegung weiter transporttierbar.

Mit der zumindest zwei Trägereinrichtungen aufweisenden Transporteinrichtung können an gegenüberliegenden Wirkungsbereichen einer Behandlungseinheit und somit beidseits einer Behandlungskammer der Behandlungseinheit mehrere zueinander gegenüberliegend angeordnete Substrate zur Oberflächenbehandlung angeordnet werden. Die Auslastung bzw. Bearbeitungskapazität der Behandlungseinheit kann insoweit deutlich gesteigert werden. Der Durchsatz an zu behandelnden Substraten bzw. die Behandlungskapazität lässt sich somit in vorteilhafter Weise steigern und verbessern.

Des Weiteren kann mittels zweier in Axialrichtung voneinander beabstandet angeordneter Trägereinrichtungen eine, bezogen auf eine Transversalebene weitgehend spiegelsymmetrische Anordnung der beiden Trägereinrichtungen der Transporteinrichtung bereitgestellt werden. Etwaige, zum hermetischen Abtrennen einzelner Prozessbereiche, etwa in Axialrichtung auf die Transporteinrichtung oder die Dichtrahmen aufzubringende Kräfte sind hierbei bevorzugt zweifach und zueinander entgegen gerichtet auf die in Axialrichtung voneinander beabstandeten Transporteinrichtungen aufzubringen. Hieraus kann eine in Axialrichtung weitgehend symmetrische mechanische Krafteinleitung und Lastverteilung bereitgestellt werden, die sich insbesondere für die Konstruktion des Außengehäuses, für den Betrieb der Transporteinrichtung sowie für die der in oder an der Behandlungskammer stattfindenden Prozesse als vorteilhaft erweisen kann.

Unabhängig hiervon und nach einer bevorzugten Ausgestaltung ist in vorteilhafter Weise eine weitgehend synchrone und gleichzeitige Bewegung der Trägereinrichtungen vorgesehen. Somit kann unter Beibehaltung einer vorgegebenen Taktzeit, die durch die Drehbewegung als solche und die einzelnen Prozessstationen vorgegeben ist, die doppelte Anzahl von Substraten in einer an sich unveränderten Art und Weise behandelt werden. Der Durchsatz der Behandlungseinrichtung kann somit um etwa 100% gegenüber einer Transporteinrichtung mit nur einer einzigen drehbar gelagerten Trägereinrichtung gesteigert werden.

Nach einer Weiterbildung sind die Halterahmen insbesondere dazu ausgebildet, die jeweils daran anordenbaren Substrate einander zugewandt in gegenüberliegende Wirkungsbereiche einer gemeinsamen, axial zwischen den Trägereinrichtungen anordenbaren Behandlungseinheit zu überführen. Insoweit können die an unterschiedlichen und axial voneinander beabstandeten Trägereinrichtungen anordenbaren Substrate bezogen auf die Axialrichtung einander zugewandt ausgerichtet und demnach den unterschiedlichen, einander gegenüberliegenden axialen Seiten- oder Behandlungsflächen der zwischen den Trägereinrichtungen anordenbaren Behandlungseinrichtung zugeordnet und entsprechend behandelt werden.

Auf diese Art und Weise können etwa axial und im Wesentlichen zueinander überdeckend angeordnete Substrate von einer einzigen gemeinsamen Behandlungseinrichtung eine gleichzeitige Behandlung erfahren.

Nach einer bevorzugten Ausgestaltung ist hierbei vorgesehen, dass die Behandlungseinheit ein eine Behandlungskammer einfassendes Gehäuse aufweist, welches gegenüber der Umgebung hermetisch abgetrennt werden kann. Hierzu sind die an den Trägereinrichtungen vorgesehenen Halterahmen als Dichtrahmen ausgebildet, die an gegenüberliegenden Gehäuseabschnitten der Behandlungskammer abdichtend zur Anlage bringbar sind.

Nach einer weiteren Ausgestaltung ist zumindest einer der Halte- oder Dichtrahmen an seiner zugeordneten oder den Halterahmen aufnehmenden Trägereinrichtung axial verschiebbar angeordnet. Mittels der genannten Axialverschiebung kann der jeweilige Halte- oder Dichtrahmen in eine nach außen abdichtende Anlagestellung mit zumindest einem Gehäuseabschnitt der Behandlungskammer überführt werden.

Der Halte- oder Dichtrahmen kann hierbei bevorzugt zum Beispiel unter Aufwendung einer in Axialrichtung wirkenden Kraft entgegen einer Rückstellkraft mit dem Behandlungskammergehäuse abdichtend zur Anlage gebracht werden. Bei Bedarf kann der Dichtrahmen infolge nachlassender Krafteinwirkung z.B. aufgrund einer federbeaufschlagten Lagerung wieder in seine Ausgangsstellung zurückkehren.

Nach einer weiteren Ausgestaltung kann alternativ oder ergänzend hierzu vorgesehen werden, dass zumindest eine der Trägereinrichtungen zumindest im Bereich ihres wenigstens einen Halterahmens relativ zur Behandlungskammer axial beweglich ausgebildet oder axial beweglich gelagert ist. Die Trägereinrichtung kann hierbei in ihrer Gesamtheit gegenüber der Behandlungskammer axial beweglich ausgebildet sein. Sie kann zum Beispiel axial verschiebbar an der Achse gelagert sein. Denkbar ist ferner, dass die Achse, respektive eine Lagerung der Trägereinrichtung gegenüber der Behandlungseinheit sowie gegenüber ihrer Behandlungskammer axial verschiebbar gelagert ist. Schließlich kann vorgesehen werden, dass die Trägereinrichtung zumindest im Bereich ihres Halte- oder Dichtrahmens axial verformbar, ggf. gegenüber der Achse verkippbar ist, um eine Abdichtung zwischen Behandlungskammergehäuse und Halte- oder Dichtrahmen der Trägereinrichtung bereitstellen zu können.

Alternativ oder ergänzend hierzu kann ferner vorgesehen werden, dass der Dichtrahmen selbst zur Expansion in Axialrichtung ausgebildet ist. Beispielsweise kann der Dichtrahmen infolge einer Beaufschlagung mit einem Expansionsmedium, wie zum Beispiel einem Gas oder einer hydraulischen Flüssigkeit eine derartige geometrischer Erweiterung und Expansion in Axialrichtung erfahren, dass eine Abdichtung zwischen Dichtrahmen und Behandlungskammergehäuse auch ohne Relativbewegung von Dichtrahmen oder Trägereinrichtung relativ zur Behandlungskammer erfolgen kann.

Nach einer weiteren bevorzugten Ausgestaltung weist die Transporteinrichtung ein die beiden Trägereinrichtungen umgebendes bzw. umschließendes Außengehäuse auf, an dessen in Axialrichtung gegenüberliegenden Außenwänden jeweils eine Schleuseneinrichtung zur Aufnahme und Entnahme von Substraten vorgesehen ist. Die gegenüberliegend an den Außenwänden der Transporteinrichtung ausgebildeten Schleuseneinrichtungen kommen in einer axialen Projektion bevorzugt im Wesentlichen überdeckend zueinander zu liegen.

Hierbei kann ferner eine synchrone bzw. miteinander gekoppelte Betätigung der Schleuseneinrichtungen vorgesehen werden, sodass etwaige in Axialrichtung auf die Schleuseneinrichtungen einwirkende Betätigungskräfte zueinander entgegen gerichtet sind.

Das Außengehäuse stellt eine hermetische Trennung und Abdichtung der Transporteinrichtung gegenüber der Außenumgebung bereit. Je nach vorgesehenem Behandlungsprozess kann die Behandlungseinrichtung gegenüber dem Innenraum des Außengehäuses nochmals hermetisch unter Verwendung der Dichtrahmen getrennt sein. Bei Behandlungsprozessen, die ein gesonderte Abdichten des Behandlungsvolumens gegenüber der Transporteinrichtung nicht erfordern können anstelle der Dichtrahmen Halterahmen oder dergleichen Haltestrukturen zum lösbaren Befestigen der Substarte an der Trägereinrichtung Verwendung finden.

So ist beispielsweise denkbar, dass das die Behandlungseinheit mit ihrer Behandlungskammer zur Durchführung einer auf Sputtern basierenden Oberflächenbehandlung ausgelegt ist. Hierzu wäre eine Abdichtung der Behandlungskammer gegenüber dem Innenraum des Außengehäuses nicht zwingend erforderlich. Jener Innenraum sollte dann jedoch ein auf den Sputterprozess abgestimmtes Druck- oder Vakuumniveau für die Vakuumbehandlung aufweisen.

Alternativ sowie ergänzend kann die Behandlungskammer gegenüber dem Innenraum des Außengehäuses abdichtend ausgestaltet sein, um darin z.B. einen Plasmabeschichtungsprozess durchzuführen. Dazu könnte der Innenraum des Außengehäuses grundsätzlich auf Atmosphärendruck liegen. Bevorzugt wird der Innenraum aber zur Einhaltung möglichst kurzer Taktzeiten, insbesondere zur Minimierung eines zu vakuumierenden Volumens, auf einem vorgegeben Druckniveau gehalten.

Nach einer Weiterbildung weist das Außengehäuse im Bereich der bevorzugt in Axialrichtung überdeckend zueinander zu liegen kommenden Schleuseneinrichtungen jeweils einen abnehmbaren und eine Öffnung für die Substrate freigebenden äußeren Schleusendeckel auf. Die innerhalb des Außengehäuses drehbar gelagerten Trägereinrichtungen sind hierbei mit ihren jeweiligen Dichtrahmen fluchtend zu jener Öffnung anordenbar und sind ferner dort durch in Axialrichtung (y) zueinander entgegen gerichtete Bewegungen jeweils an der Innenseite des Außengehäuses abdichtend zur Anlage bringbar. Die Bewegung des Dichtrahmens kann hier analog zur abdichtenden Anlage am Behandlungskammergehäuse durch eine Relativverschiebung von Dichtrahmen und Trägereinrichtung, von Trägereinrichtung und Außengehäuse sowie durch eine Expansion des Dichtrahmens, respektive seiner Dichtung erfolgen.

In Weiterbildung hiervon ist ferner vorgesehen, dass im Bereich der Schleuseneinrichtungen zwei zwischen den Trägereinrichtungen angeordnete innere Druckplatten, welche als Schleusendeckel fungieren können, in Axialrichtung verschiebbar angeordnet sind, die mittels eines, bevorzugt eines einzigen Betätigungsmechanismus mit einer Innenseite der Dichtrahmen in Anlagestellung bringbar sind. Der Betätigungsmechanismus sowie die von ihm betätigbaren Schleusendeckel sind hierbei, bezogen auf die Axialrichtung (y) zwischen den Trägereinrichtungen angeordnet. In vorteilhafter Weise ist hierdurch eine gleichzeitige und entgegen gerichtete Betätigung und Axialverschiebung der Schleusendeckel mit nur einem einzigen Betätigungsmechanismus erreichbar.

Ein einziger Betätigungsmechanismus ist insoweit ausreichend, um die zumindest zwei inneren Druckplatten, respektive Schleusendeckel weitgehend synchron bzw. entgegengerichtet symmetrisch und gleichzeitig zur Verschiebung der fluchtend hierzu anordenbaren Dichtrahmen der beiden Trägereinrichtungen zu bewegen. Es erweist sich hierbei insbesondere als vorteilhaft, dass der Betätigungsmechanismus selbst kaum eine Gegenkraft zur Betätigung der Schleusendeckel aufbringen muss.

Gemäß einer Weiterbildung kann der Betätigungsmechanismus gegenüber dem Außengehäuse der Transporteinrichtung ortsfest angeordnet sein und mit beiden inneren Druckplatten, respektive Schleusendeckeln zur Ausübung zueinander entgegengerichteter Druckkräfte in Wirkverbindung bringbar sein. Insoweit muss der Betätigungsmechanismus selbst keine zur Betätigung eines einzelnen Schleusendeckels erforderliche Gegenkraft bereitstellen. Er ist bevorzugt zur Ausübung zueinander diametral entgegen gerichteter Druckkräfte auszulegen. Der Betätigungsmechanismus kann hierzu zum Beispiel einen einzigen, mit beiden Druckplatten entgegen gerichtet in Wirkverbindung stehenden Exzentermechanismus aufweisen.

Die Verankerung des Betätigungsmechanismus gegenüber dem Außengehäuse muss insoweit keine nennenswerten Kräfte aufnehmen oder in das Außengehäuse ableiten. Ferner ermöglicht das beschriebene Konzept eine weitgehend einfache, ggf. sogar auswechselbare Anordnung des Betätigungsmechanismus im oder am Außengehäuse der Transporteinrichtung.

Nach einer weiteren bevorzugten Ausgestaltung weisen die Trägereinrichtungen jeweils einen sich im Wesentlichen in einer Ebene senkrecht zur Axialrichtung (y) erstreckenden Drehteller mit daran entgegen einer Rückstellkraft auslenkbaren Dichtrahmen auf. Der jeweilige Drehteller erstreckt sich, bezogen auf die Axialrichtung (y), transversal. Der Drehteller als solcher kann hierbei ein weitgehend geschlossen ausgebildetes Flächengebilde oder aber eine skelettartige Trägerstruktur bereitstellen, an welcher der zumindest eine, bevorzugt mehrere über die Ebene des Drehtellers verteilt angeordnete Dichtrahmen vorgesehen sind.

Der zumindest eine Dichtrahmen kann am Drehteller bzw. an der Trägereinrichtung zum Beispiel mittels einer oder mehrerer Federelemente in Axialrichtung federnd gelagert sein. Eine federnde Lagerung kann insbesondere mittels einer Anzahl von sich radial nach außen am Dichtrahmen erstreckenden Fortsätzen bereitgestellt werden, welche ihrerseits mittels einer oder mehrerer Druckfedern in einem radial nach innen geöffneten U- oder C-förmigen Halterahmen der Trägereinrichtung in Axialrichtung verschiebbar aufgenommen sind.

Nach einer weiteren Ausgestaltung kann ferner vorgesehen sein, dass die Trägereinrichtungen, insbesondere die Drehteller zumindest im Bereich ihres wenigstens einen, bevorzugt im Bereich sämtlicher Dichtrahmen in Axialrichtung reversibel deformierbar ausgebildet sind. Die axiale Auslenkung des Dichtrahmens und/oder der Trägereinrichtung bzw. des Drehtellers kann im Bereich einiger weniger Millimeter liegen, sodass eine Abdichtung im Bereich der Behandlungskammer und/oder im Bereich der Schleuseneinrichtungen ggf. auch ohne eine in Axialrichtung wirkende verschiebbare Lagerung von Dichtrahmen und/oder Trägereinrichtungen in ausreichendem Maß bereitgestellt werden kann.

Nach einer weiteren bevorzugten Ausgestaltung ist ferner vorgesehen, dass die Trägereinrichtungen und/oder die Dichtrahmen im Wesentlichen vertikal und/oder die Achse, um welche die Trägereinrichtungen rotierbar sind, im Wesentlichen horizontal ausgerichtet sind. Die Ebene, in welcher die Trägereinrichtungen drehbar sind, verläuft bevorzugt im Wesentlichen parallel zur Schwerkraft, sodass die an unterschiedlichen Dichtrahmen befestigbaren Substrate bei ihrer Behandlung etwa im Bereich der Behandlungskammer, bezogen auf die Schwerkraftwirkung, weitgehend symmetrisch bzw. identisch angeordnet und ausgerichtet sind.

Hierdurch kann in vorteilhafter Weise erreicht werden, dass sämtliche an den unterschiedlichen Trägereinrichtungen befestigbaren Substrate eine weitgehend identische Behandlung im Bereich der Behandlungskammer erfahren können. Im Falle einer als Plasmabehandlungsstation ausgebildeten Behandlungseinheit können auf diese Art und Weise zudem etwaige Schwerkrafteffekte, die mitunter zu Verunreinigungen des zu beschichtenden Substrates führen können, weitreichend umgangen oder beseitigt werden.

Nach einer weiteren bevorzugten Ausgestaltung sind im Bereich der Behandlungskammer von außen an die Dichtrahmen zur Anlage bringbare und in Axialrichtung (y) bewegliche Druckeinrichtungen vorgesehen, die im Zuge einer aufeinander zu gerichteten Bewegung dazu ausgebildet sind, die Dichtrahmen der gegenüberliegenden Trägereinrichtungen weitgehend symmetrisch und synchron in eine mit der Behandlungskammer abdichtende Anlagestellung zu überführen.

Ähnlich wie der für die Schleusenbetätigung vorgesehene Betätigungsmechanismus kann auch hier eine einzige Druckeinrichtung vorgesehen sein, mittels derer zueinander entgegen gerichtete, bezogen auf die Behandlungskammer axial nach innen gerichtete und von außen an gegenüberliegenden Gehäuseabschnitten der Behandlungskammer in Anlage bringbare Druckeinrichtungen, etwa in Form von Druckplatten oder dergleichen eine gegenseitige Abstützung erfahren. Die zur Betätigung einer Druckeinrichtung aufzubringende Kraft, insbesondere die hiermit korrespondierende Gegenkraft kann in vorteilhafter Weise auf die gegenüberliegende Druckeinrichtung übertragen werden.
Es erweist sich hierbei als vorteilhaft, dass das die Behandlungskammer umfassende Außengehäuse insoweit keine zur Betätigung der Druckeinrichtungen erforderliche Gegenkraft aufbringen oder aufnehmen muss.

Nach einer weiteren bevorzugten Ausgestaltung sind die beiden Trägereinrichtungen mit ihren Dichtrahmen ferner in den Bereich einer z.B. als Heizeinrichtung ausgebildeten Behandlungseinrichtung verschwenkbar, welche jeweils zwei an gegenüberliegenden Abschnitten des Außengehäuses der Transporteinrichtung nach innen gewandte Heizelemente und/oder zumindest ein zwischen den Trägereinrichtungen zu liegen kommendes, nach außen gerichtetes Heizelement aufweist. Mittels der Heizeinrichtung können die an der Transporteinrichtung befestigten Substrate insbesondere vor ihrer Behandlung im Bereich der Behandlungskammer auf eine für den jeweiligen Behandlungsprozess geeignete Temperatur aufgeheizt werden.

Für den Oberflächenbehandlungsprozess der Substrate sind bevorzugt zumindest drei einzelne Prozessstationen, nämlich eine Schleuse, eine Heizeinrichtung sowie eine Behandlungskammer vorgesehen. Diese sind bevorzugt in Umfangsrichtung der Trägereinrichtungen gleich verteilt bzw. äquidistant angeordnet, sodass in jeder Halteposition der Transporteinrichtung an sämtlichen Prozessstationen die dort jeweils vorgesehenen Bearbeitungs- oder Behandlungsschritte gleichzeitig durchgeführt werden können. Die Anzahl sowie die relativen Positionen der einzelnen Behandlungseinrichtungen können hierbei auch variieren. Ist der durchzuführende Oberflächenbehandlungsprozess in mehrere Teilprozesse unterteilt können an der Transporteinrichtung mehrere Behandlungseinheiten in Umfangsrichtung verteilt vorgesehen werden.

Nach einem weiteren unabhängigen Aspekt betrifft die Erfindung ferner eine Vakuumbehandlungseinrichtung mit einer zuvor beschriebenen Transporteinrichtung. Die Vakuumbehandlungseinrichtung ist insbesondere zur Oberflächenbehandlung der mittels der Transporteinrichtung transportierbaren Substrate vorgesehen. Die Vakuumbehandlungseinrichtung weist eine Behandlungseinheit, bevorzugt mit einer Behandlungskammer, weiter bevorzugt eine Vakuum- bzw. Plasmabehandlungskammer auf, die z.B. zur Anregung eines innerhalb der Plasmabehandlungskammer und zwischen zumindest zwei jeweils an unterschiedlichen Trägereinrichtungen lösbar angeordneten und zu behandelnden Substraten befindlichen Plasmas ausgebildet ist.

Die die Substrate aufnehmenden Halterahmen sind dabei in Axialrichtung gegenüberliegende Behandlungs- oder Wirkungsbereiche der Behandlungseinheit bringbar, sodass mittels einer einzigen Behandlungseinheit gleichzeitig zwei gegenüberliegend, beidseits der Behandlungseinheit angeordnete Substrate entsprechend dem jeweils vorgesehenen Oberflächenbehandlungsprozess behandelbar sind.

In bevorzugter Ausgestaltung ist die Behandlungseinheit zur Anregung eines bevorzugt innerhalb einer Behandlungskammer zu bildenden jedenfalls zwischen zwei zu behandelnden Substraten vorzusehenden Plasmas ausgebildet. Die die Substrate aufnehmenden Halterahmen können hierbei bevorzugt als Dichtrahmen ausgebildet sein und an in Axialrichtung zueinander gegenüberliegenden Gehäuseabschnitten der Behandlungskammer abdichtend zur Anlage bringbar sein.

Die Behandlungseinrichtung ist hierbei keinesfalls auf Plasmabehandlungsprozesse beschränkt sondern kann universell für Physikalische Abscheidungsprozesse (PVD) insbesondere auch für auf Sputtern basierende Behandlungsprozesse verwendet werden. Wenngleich eine zueinander abgedichtete oder abdichtbare Ausgestaltung von Behandlungskammer und Innenraum des Außengehäuses von Vorteil sein kann ist die Erfindung in keinster Weise auf solche Ausführungsformen beschränkt.

So kann insbesondere im Hinblick auf solche Oberflächenbehandlungsprozesse, die z.B. auf Sputtern basieren, auch eine nicht abdichtende Anordnung einzelner oder mehrerer Halterahmen gegenüber der Behandlungskammer, insbesondere gegenüber deren Gehäuse gleichermaßen vorgesehen werden.

In vorteilhafter Weiterbildung hiervon ist vorgesehen, dass die Plasmabehandlungseinheit eine außerhalb der Plasmabehandlungskammer, aber innerhalb des Außengehäuses der Transporteinrichtung angeordnete Anregungsspule zur induktiven Anregung eines Plasmas innerhalb der Behandlungskammer aufweist. Insoweit ist der Innenraum der Plasmabehandlungskammer plasmabehandlungsspulenfrei ausgebildet. Die Spule befindet sich vollständig außerhalb der Plasmabehandlungskammer in einem Bereich, in welchem derartige Randbedingungen herrschen, dass eine Plasmaerzeugung gemäß dem Paschengesetz nicht möglich ist. Ist die Plasmabehandlungseinheit zum Beispiel als Beschichtungseinheit ausgebildet, so wird die Spule infolge der Plasmaerzeugung selbst nicht beschichtet.

Des Weiteren ist nach einer vorteilhaften Ausgestaltung vorgesehen, dass die Plasmabehandlungseinheit mit einem die Plasmabehandlungskammer umschließenden Innengehäuse lösbar am Außengehäuse der Transporteinrichtung anordenbar ist. Die Plasmabehandlungseinheit kann insoweit mit ihrem Innengehäuse als ein austauschbares Modul ausgebildet sein, welches je nach Anforderungen der Vakuumbehandlungseinrichtung nach Belieben durch andere Behandlungsmodule ausgetauscht werden kann. Eine vergleichbare modulare Ausgestaltung kann hierbei auch für die Heizeinrichtung vorgesehen werden, insbesondere wenn sie lediglich ein, in Axialrichtung zwischen den Trägereinrichtungen zu liegen kommendes Heizelement oder mehrere Elemente aufweist.

Nach einer weiteren bevorzugten Ausgestaltung umschließt die Anregungsspule die Plasmabehandlungskammer in einer Ebene (x, z) senkrecht zur Axialrichtung (y). Die Anregungsspule steht hierbei mit einem Innenraum des Außengehäuses der Transporteinrichtung in Verbindung. Das heißt, die Anregungsspule befindet sich auf dem Druckniveau und in einer atmosphärischen Umgebung, welche innerhalb des Außengehäuses der Transporteinrichtung herrscht. Hiervon ist das Innengehäuse der Plasmabehandlungseinheit, respektive die Plasmabehandlungskammer hermetisch getrennt.

In Weiterbildung hiervon ist schließlich vorgesehen, dass die Plasmabehandlungskammer mit einer das Innengehäuse in einem Anbindungsbereich an das Außengehäuse durchsetzenden Absaugung in Strömungsverbindung steht. Die mit dem Innengehäuse bzw. mit der Plasmabehandlungskammer in Strömungsverbindung stehende Absaugung durchsetzt die Innengehäusekammerwand folglich in einem Gehäuseabschnitt der Plasmabehandlungskammer, weleher im Bereich einer für das Plasmabehandlungsmodul vorgesehenen Aufnahme des Außengehäuses der Transporteinrichtung liegt.

Auf diese Art und Weise kann die weitgehend vollständig im Innenraum des Außengehäuses liegende Plasmabehandlungskammer mit einer das Außengehäuse durchsetzenden Absaugung gekoppelt sein, die es ermöglicht, innerhalb der Plasmabehandlungskammer völlig andere Prozessbedingungen hinsichtlich Gasgemischzusammensetzung und Druck bereitzustellen.

Nach einer weiteren bevorzugten Ausgestaltung kann ferner vorgesehen werden, dass eine mit der Plasmabehandlungskammer in Strömungsverbindung bringbare Absaugung durch eine Druckeinrichtung hindurch erfolgt, mittels derer der zumindest eine Dichtrahmen in eine abdichtende Anlagestellung an der Behandlungskammer bringbar ist. Hierbei ist insbesondere vorgesehen, dass die Druckeinrichtung kein geschlossenes Flächengebilde, sondern eine z.B. speichen- oder skelettartige Struktur aufweist, mittels derer der die Substrate aufnehmende Dichtrahmen gegen das Behandlungskammergehäuse gedrückt werden kann.

Eine hermetische Trennung zwischen Behandlungskammer und Innenraum der Transporteinrichtung kann hierbei mittels Dichtelementen erfolgen, die einerseits an der jeweiligen Druckeinrichtung und andererseits an der Innenwand des Außengehäuses jeweils abdichtend angeordnet sind. Die Dichtelemente können hierbei eine die Bewegung der Dichtrahmen ermöglichende Flexibilität oder mechanische Deformierbarkeit aufweisen.

Nach einer weiteren bevorzugten Ausgestaltung weist die Behandlungseinheit axial nach außen versetzt zur Behandlungskammer zumindest eine Außenbehandlungseinheit auf, mittels welcher eine der Behandlungskammer abgewandte Seite des zumindest einen Substrats behandelbar ist. Auf diese Art und Weise können Substrate auch gleichzeitig beidseits behandelt werden. Sofern das Substrate abdichtend am Halterahmen gehaltert ist kann mit der innenliegenden Behandlungskammer an der Innenseite des Substrats eine andere Oberflächenbehandlung als an der Außenseite durchgeführt werden. Ohne gastechnische Trennung wären beide gegenüberliegende Seiten des Substrats weitgehend identisch behandelbar.

Auch kann nach einer weiteren Ausgestaltung vorgesehen werden, dass das Außengehäuse und/oder die Behandlungseinheit zumindest ein Heizelement aufweist, welches zum Heizen einer der Behandlungskammer abgewandten Substratseite vorgesehen ist. Die Substrate wären dann im Bereich der Behandlungseinrichtung somit beidseitig behandelbar. Von einer Innenseite her wäre ein Oberflächenbehandlungsprozess durchführbar währenddessen das Substrat von einer Rückseite geheizt und/oder auf einer für den Behandlungsprozess vorgesehenen Temperatur gehalten wird.

Die beschriebene Transporteinrichtung als auch die hiermit ausgestattete Vakuumbehandlungseinrichtung können bevorzugt für PECVD-Beschichtungsverfahren sowie auf eine Vielzahl weiterer Beschichtungs- sowie Oberflächenbehandlungsverfahren insbesondere auch für Sputterprozesse universell eingesetzt werden. Neben Beschichtungen können die genannten Einrichtungen auch gleichermaßen für Ätz- oder für Reinigungsprozesse Verwendung finden, ohne hierbei auf plasmaunterstützte Oberflächenbehandlungsprozesse beschränkt zu sein.

Auch ist denkbar, dass die Behandlungseinheit ohne gesonderte Abdichtung gegenüber dem Innenraum des Außengehäuses universell zur Erzeugung eines zwischen gegenüberliegenden Substraten zu bildenden Plasmas ausgebildet ist. Ferner gelten sämtliche in Bezug zur Transporteinrichtung beschriebenen sowie beanspruchten Merkmale sowie Vorteile gleichermaßen für die übergeordnete Vakuumbehandlungseinrichtung, und umgekehrt.

### Kurzbeschreibung der Figuren

Weitere Ziele, Merkmale sowie vorteilhafte Anwendungsmöglichkeiten der Erfindung werden in der nachfolgenden Beschreibung von Ausführungsbeispielen beschrieben. Hierbei bilden sämtliche in den Figuren bildlich dargestellten als auch in der Beschreibung beschriebenen Merkmale den Gegenstand der vorliegenden Erfindung. Es zeigen:
- Fig. 1: eine geschnittene Darstellung der Transporteinrichtung von oben betrachtet mit in Ausgangsstellung befindlichen Dichtrahmen,
- Fig. 2: die Transporteinrichtung gemäß Fig. 1 mit in Anlagestellung befindlichen Dichtrahmen,
- Fig. 3: eine von der Ausgestaltung der Fig. 1 und 2 abweichende Ausgestaltung der mit den Dichtrahmen im Bereich der Plasmabehandlungskammer in Wirkverbindung tretenden Druckeinrichtungen,
- Fig. 4: eine isolierte Darstellung einer möglichen Heizeinrichtung,
- Fig. 5: eine der Fig. 4 entsprechende geschnittene Darstellung einer weiteren Ausgestaltung einer Heizeinrichtung,
- Fig. 6: eine isolierte Darstellung einer federbeaufschlagten Lagerung eines an der Behandlungskammer anliegenden Dichtrahmens,
- Fig. 7: eine in Ausgangsstellung im Bereich der Schleuseneinrichtung liegenden Dichtrahmen und
- Fig. 8: einen mittels des Betätigungsmechanismus nach außen, in Anlagestellung mit der Gehäusewand tretenden Dichtrahmen im Bereich der Schleuseneinrichtung.

### Detaillierte Beschreibung

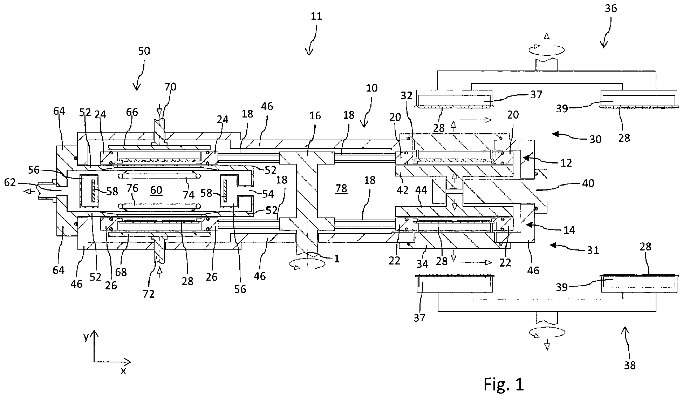

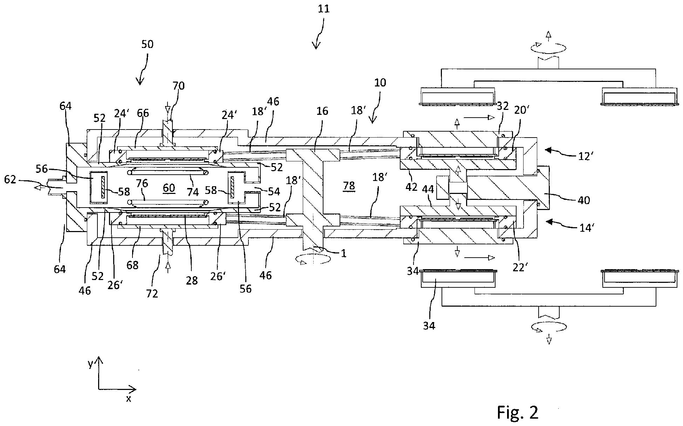

In den Fig. 1 und 2 ist eine Vakuumbehandlungseinrichtung 11 in einem Querschnitt von oben gezeigt. Die Vakuumbehandlungseinrichtung 11 weist eine Transporteinrichtung 10 auf, welche zwei in Axialrichtung (y) voneinander beabstandete Trägereinrichtungen 12, 14 aufweist, die gemeinsam um eine sich im Wesentlichen in Axialrichtung (y) erstreckende Achse 1 drehbar gelagert sind. In Fig. 1 ist ein Querschnitt dargestellt, welcher rechts zwei Schleuseneinrichtungen 30, 31 und links eine gemeinsame Plasmabehandlungseinheit 50 mit einer Plasmabehandlungskammer 60 aufweist.

Die Trägereinrichtungen 12, 14 weisen eine Tragstruktur 18 auf, an welcher entsprechend der Darstellung gemäß Fig. 1 und 2 jeweils zumindest zwei in Axialrichtung (y) bewegliche Dichtrahmen 20, 22, 24, 26 angeordnet sind. Wie in den Figuren dargestellt, weisen sämtliche Dichtrahmen 20, 22, 24, 26 bezogen auf die Axialrichtung (y) an gegenüberliegenden Endabschnitten in den Figuren nicht näher angezogene Dichtungen, etwa O-Ringe auf, mittels welchen die einzelnen Dichtrahmen 20, 22, 24, 26 abdichtend im Bereich der Behandlungskammer 60 als auch im Bereich der in Axialrichtung gegenüberliegenden Schleusen 30, 31 werden können. Bei der Vakuumbehandlungseinheit 50 sind die Dichtrahmen 20, 22, 24, 26 von außen am Behandlungskammergehäuse 52 und bei der Schleuseneinrichtungen 30, 31 an der Innenwand des Außengehäuses 46 der Transporteinrichtung 10 respektive der Vakuumbehandlungseinrichtung 11 jeweils abdichtend zur Anlage bringbar.

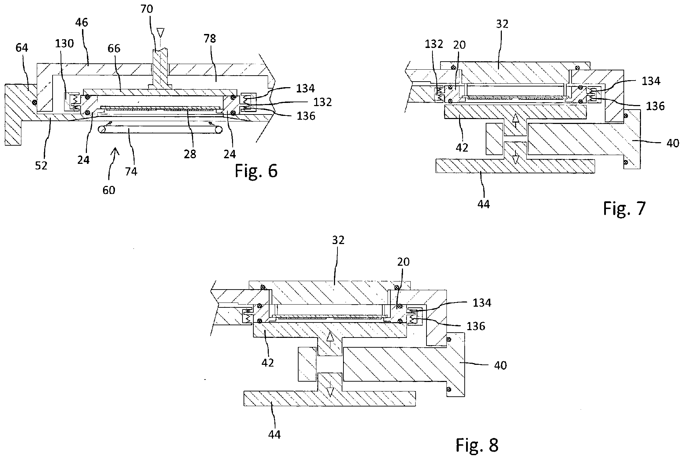

Die einzelnen Dichtrahmen 20, 22, 24, 26 können hierbei, wie in den Fig. 6, 7 und 8 dargestellt, zum Beispiel mittels eines Federmechanismus 134, 136 am trägerseitigen Halterahmen 130 in Axialrichtung (y) entgegen der jeweiligen Federkraft verschiebbar gelagert sein. Die in den Fig. 6 bis 8 gezeigten Dichtrahmen 20, 24 weisen hierfür einen radial nach außen ragenden Zapfen oder Flansch 132 auf, der sich in Axialrichtung (y) zwischen zwei Druckfedern 134, 136 befindet. Wie zum Beispiel in Fig. 6 dargestellt, kann der an der Trägereinrichtung 12 verschiebbar gelagerte Dichtrahmen 24 mittels einer sich über die Fläche des Rahmens 24 erstreckenden Druckplatte 66 und unter Verwendung eines Druckstempels 70, welcher eine in Fig. 6 nach unten gerichtete Druckkraft bereitstellt, entgegen der Kraft der Feder 136 abdichtend gegen das Gehäuse 52 der Plasmabehandlungskammer 60 gedrückt werden.

Der Dichtrahmen 24 schließt hierbei hermetisch gegenüber der Kammerwand 52 als auch gegenüber der Druckplatte 66 ab, sodass der von der Druckplatte 66 und dem Dichtrahmen 24 gebildete Bereich strömungstechnisch mit dem Innenraum der Plasmabehandlungskammer 60 verbunden, zugleich aber vom übrigen Innenraum 78 des Außengehäuses 46 hermetisch getrennt ist.

Die in den Fig. 6 bis 8 gezeigten U- oder C-förmigen Halterungen 130 können fest mit der Tragstruktur der Trägereinrichtungen 12, 14 und somit in Axialrichtung unbeweglich mit einem Achslager 16 der Transporteinrichtung 10 verbunden sein.

Im Bereich der Behandlungskammer 60 ist vorgesehen, die beiden gegenüberliegend an unterschiedlichen Seiten des Behandlungskammergehäuses 52 zur Anlage bringbaren Dichtrahmen 24, 26 mittels jeweils von außen an den Dichtrahmen 24, 26 zur Anlage bringbaren Druckplatten 66, 68 mit dem Gehäuse 52 abdichtend zur Anlage zu bringen. Die hierfür erforderlichen, jeweils nach innen gerichteten Druckkräfte können hierbei mittels zweier entgegen gerichteter, im Wesentlichen symmetrisch ausgebildeter Druckstempel 70, 72 aufgebracht werden. Die Druckstempel 70, 72 können hierbei in einer nicht explizit gezeigten Art und Weise außerhalb des Außengehäuses 46 mechanisch und kraftübertragend bzw. kraftausgleichend miteinander gekoppelt werden, sodass vom Außengehäuse 46 der Transporteinrichtung 10 keine nennenswerte Gegenkraft für die Druckstempelbetätigung 70, 72 aufgebracht werden muss.

Im Bereich der in den Fig. 1 und 2 rechts dargestellten und in Axialrichtung (y) im Wesentlichen überdeckend zueinander zu liegen kommenden Schleuseneinrichtungen 30, 31 ist eine entgegengesetzte Bewegung der dort vorgesehenen Dichtrahmen 20, 22 vorgesehen. Diese sind mittels jeweils einer sich in Axialrichtung (y) zwischen den Trägereinrichtungen 12, 14 befindlichen Druckplatte 42, 44 jeweils nach außen, in Fig. 1 nach oben und nach unten gegen die Innenwand des Außengehäuses 46 abdichtend zur Anlage bringbar. Ein lediglich angedeuteter Betätigungsmechanismus 40 ist hierbei dazu ausgelegt, zueinander entgegen gerichtete Druckkräfte möglichst gleichmäßig auf die Druckplatten 42, 44 aufzubringen.

Auch hierbei erfolgt keine einseitige und asymmetrische mechanische Belastung des Außengehäuses 46 oder der die Trägereinrichtungen 12, 14 miteinander koppelnden Lagerachse 16. Ferner ist zur Bereitstellung zweier Schleuseneinrichtungen 30, 31 lediglich ein einziger kraftaufwendender Betätigungsmechanismus 40 vorzusehen.

Die in Axialrichtung (y) gegenüberliegenden Schleuseneinrichtungen 30, 31 weisen jeweils einen ebenfalls abdichtend von außen am Außengehäuse 46 zur Anlage bringbaren Schleusendeckel 32, 34 auf. In der in Fig. 2 schematisch dargestellten Konfiguration, in welcher die Dichtrahmen 20', 22' jeweils abdichtend am Außengehäuse 46 anliegen, kann der jeweilige Schleusendeckel 32, 34 zur Entnahme und/oder zur Aufnahme von Substraten 28 geöffnet werden. In den Fig. 1 und 2 ist ferner eine Bestückungseinrichtung dargestellt, welche jeweils zwei Be- und Entladeeinheiten 36, 38 mit jeweils zwei drehbar hieran gelagerten Substrathalteeinrichtungen 37, 39 aufweist.

In Fig. 2 ist eine gleichzeitige Aktivierung sowohl des Betätigungsmechanismus 40 als auch der Druckstempel 70, 72 gezeigt, die zu einer in Fig. 2 übertrieben dargestellten axialen Verformung der Trägerstruktur 18 der Trägereinrichtungen 12, 14 führen kann. Anstelle einer etwa elastisch deformierbaren Ausgestaltung der Trägereinrichtungen 12, 14 kann eine Druckbeaufschlagung der jeweiligen Dichtrahmen 20, 22, 24, 26 insbesondere auch mittels der in den Fig. 6 bis 8 gezeigten, federgelagerten Ausgestaltung vorgesehen sein.

Nach der Erfindung erweist es sich als besonders vorteilhaft, wenn eine zu Beschichtungszwecken vorgesehene, eine Plasmabehandlungskammer 60 aufweisende Plasmabehandlungseinheit 50, zwischen den in Axialrichtung (y) voneinander beabstandet angeordneten Substraten 28 angeordnet ist. Die zum Beispiel in den Fig. 1, 2 und 3 gezeigte Plasmabehandlungskammer 60 sieht eine außerhalb der Kammer angeordnete induktive Anregungsspule 58 vor, sodass innerhalb der Plasmakammer 60 lediglich ein Gasverteilungssystem 74, 76 zum Einleiten der etwa für einen Beschichtungsvorgang vorzusehenden Prozessgase angeordnet ist.

Der Innenraum der Behandlungskammer 60 wird hierbei ringförmig in der y-z-Ebene von der außerhalb der Kammer liegenden plasma-erzeugenden Spule 58 eingeschlossen. Die Spule 58 befindet sich hierbei in atmosphärischer Verbindung mit dem Innenraum 78 des Außengehäuses 46, während der Innenraum der Plasmakammer 60 hiervon hermetisch getrennt ist und mittels einer Absaugung 62 auf einem völlig anderen Druckniveau betrieben werden kann.

Die außerhalb der Plasmabehandlungskammer liegende Anregungsspule hat ferner den Vorteil, dass für die induktive Anregung des Plasma keine zur Plasmabildung erforderlichen Elektroden innerhalb der Vakuumkammer angeordnet werden müssen. Auch können die zur Halterung der Substrate 28 vorgesehenen und an den Dichtrahmen 20, 22, 24, 26 lösbar gehaltenen Substrathalter vollkommen unabhängig von der Plasmaquelle selbst ausgebildet sein.

Die Plasmaquelle, insbesondere die Anregungsspule 58 ist hierbei derart zum Einkoppeln elektromagnetischer Energie in die Plasmabehandlungskammer 60 ausgebildet, dass ein das Plasma bildendes Gasgemisch ausschließlich im sogenannten H-Modus betreibbar ist bzw. im H-Modus brennen kann. Kennzeichnend für die hier bevorzugt vorgesehene induktive Anregung ist es, dass die H-Mode im Plasma überwiegt, zumindest aber, dass ein merklicher, bevorzugt ein überwiegender Anteil des Energietransfers zum Plasma über die sog. H-Mode erfolgt. Für eine eingehendere Erörterung der H-Mode wird an dieser Stelle zum Beispiel auf die von Victor Kadetov verfasste Dissertation "Diagnostics and Modeling of an inductively coupled radio frequency discharge in hydrogen", Fakultät für Physik und Astronomie, Ruhr-Universität Bochum 2004", Seiten 14 ff verwiesen.

Es ist gemäß der Ausgestaltung nach den Fig. 1 bis 3 ferner vorgesehen, dass die gesamte Plasmabehandlungskammer 60 mitsamt ihrem Innengehäuse 52 modulartig und lösbar in das Außengehäuse 46 der Transporteinrichtung 10 eingesetzt werden kann. Das Innengehäuse 52 geht in Fig. 1 nach links außen betrachtet in einen verbreiterten Flanschabschnitt 64 über, mittels welchem das Plasmabehandlungseinheit oder -modul 50 abdichtend am Außengehäuse 46 und mit seiner Plasmakammer 60 innerhalb des Außengehäuses 46 in Axialrichtung zwischen den Trägereinrichtungen 12, 14 liegend angeordnet werden kann.

Die Plasmabehandlungseinheit 50 weist ferner eine über einen Durchgang 54 nach außen hin offenen Ringraum 56 auf, in welchem die Anregungsspule 58 angeordnet ist. Aufgrund des Durchgangs 54 ist der Ringraum 56 in Strömungsverbindung mit dem Innenraum 78 des Gehäuses 46. Indem man im Innenraum 78 und somit auch insbesondere im Ringraum 56 derartige Randbedingungen hinsichtlich Gaszusammensetzung und Druckniveau schafft, sodass bei einer Hochfrequenzbeaufschlagung der Anregungssspule 58 eine dem Plasmazündungsbedingung gemäß dem Paschengesetz im Innenraum 78 nicht geschaffen wird. Somit kann eine Plasmazündung bzw. Plasmaerzeugung auf den Innenraum der Behandlungskammer 60 in vorteilhafter Weise beschränkt werden.

Das zur Aufnahme der Anregungsspule 58 vorgesehene und als Ringraum 56 bezeichnete Volumen muss dabei keinesfalls radialsymmetrisch oder ringförmig ausgebildet sein. Es kann insbesondere entsprechend der Substrat- sowie Behandlungskammergeometrie auch rechteckig oder quadratisch in der Transversalebene liegend (x, z) ausgebildet sein. In sämtlichen in den Figuren dargestellten Ausgestaltungen erstreckt sich eine die Axialrichtung bezeichnende γ-Achse in horizontaler Richtung, sodass eine Drehebene der Trägereinrichtungen 12, 14 sowie die Ebene der zu behandelnden Substrate 28 im Wesentlichen parallel zur Schwerkraftrichtung liegen.

In der Ausgestaltung gemäß der Fig. 1, 2 und 3 bilden die mit den Dichtrahmen 24, 26 in Anlagestellung bringbaren und nach innen zum Kammerinnenraum hin verschiebbaren Druckplatten 66, 68 eine den Substraten 28 abgewandte Behandlungskammergehäusewandung.

Die Druckplatten 66, 68 dichten den Kammerinnenraum 60 gegenüber dem Gehäuseinnenraum 78 hermetisch ab. Das Absaugen von Prozessgasen aus der Behandlungskammer 60 erfolgt über die Absaugung 62, welche in einem Bereich durch das Gehäuse der Plasmabehandlungseinrichtung 50 geführt ist, der zugleich das Außengehäuse 46 der Transporteinrichtung 10 in radialer Richtung durchsetzt.

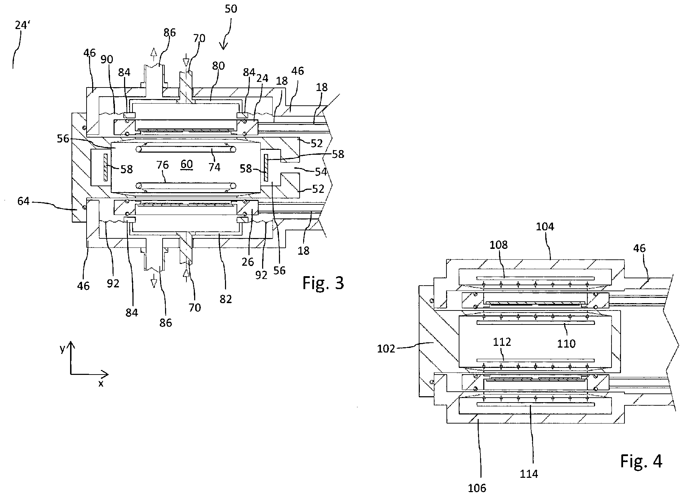

In Fig. 3 ist eine hiervon abweichende Konfiguration gezeigt. Zwar ist auch hier ein in das Gehäuse 52 der Plasmakammer 60 eingelassener Ringraum 56 vorgesehen. Allerdings erfolgt hier eine Absaugung durch die mit den Dichtrahmen 24, 26, in Anlagestellung tretenden Druckeinrichtungen 80, 82. Deren mit den Dichtrahmen 24, 26 in Anlagestellung tretenden Druckstücke 84 sind über flexibel ausgestaltete Trennelemente 90, 92 abdichtend mit der Innenwand des Außengehäuses 46 verbunden. Die Druckeinrichtungen 80, 82 selbst sind hierbei gasdurchlässig ausgebildet, um eine in Axialrichtung 86, 88 an das Außengehäuse 46 ragende Absaugung 86, 88 zu ermöglichen. Selbstredend kann hierbei auch eine mit einer eigenen Absaugung 62 versehene Vakuumbehandlungseinrichtung 50, wie sie in den Fig. 1 und 2 gezeigt ist, die in Fig. 3 gezeigte Vakuumbehandlungseinrichtung ersetzen. Die Absaugung der Behandlungskammer 60 wäre dann über insgesamt drei Absaugrohre 62, 86, 88 sowohl in Radial- als auch in Axialrichtung möglich.

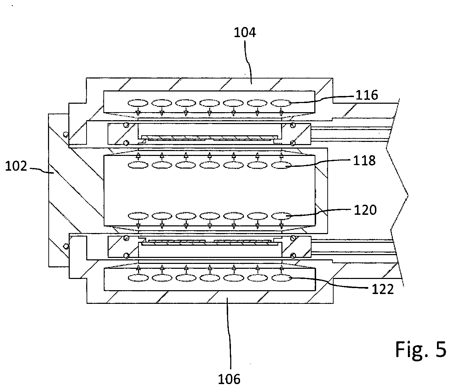

In den Fig. 4 und 5 sind schließlich zwei verschiedene Ausgestaltungen von denkbaren Heizeinrichtungen 100 gezeigt, welche ebenfalls als Behandlungseinheit fungieren können. Gemäß der Ausführung nach Fig. 4 wird hier ein mit zwei Flächenheizelementen 110, 112 bestücktes Heizmodul 102 radial nach innen in eine hierfür vorgesehene Aufnahme des Außengehäuses 46 der Transporteinrichtung 10 eingesetzt. Zugleich können im Bereich des Außengehäuses 46 gegenüberliegende, etwa zur Aufnahme von weiteren Flächenheizelementen 108, 114 vorgesehene Vertiefungen 104, 106 vorgesehen werden, sodass die in Axialrichtung (y) im Wesentlichen übereinanderliegenden Substrate 28 zusammen mit ihren hierfür vorgesehenen Halterungen von beiden Seiten auf ein vorgegebenes Temperaturniveau aufgeheizt werden können.

Die Fig. 5 zeigt eine der Fig. 4 ähnliche Ausgestaltung, wobei jedoch sämtliche Flächenheizelemente 110, 112 durch einzelne Heizstrahler 116, 118, 120, 122 ausgetauscht sind. Es ist hierbei grundsätzlich denkbar, dass die Heizeinrichtungen 100 sowohl mit zwischen den Substraten liegenden Heizelementen 110, 112 sowie 118, 120 als auch ausschließlich mit außerhalb und ortsfest am Au-ßengehäuse 46 vorgesehenen bzw. hieran angeordneten Heizelementen 108, 114, 116, 122 variabel ausgestaltet sein können.

Es versteht sich von selbst, dass die Art und Weise der Heizeinrichtung natürlich auch den in der Plasmabehandlungskammer 60 durchzuführende Behandlungsprozess abgestimmt sind. Die Schleuseneinrichtungen 30, 31, die Plasmabehandlungseinrichtung 50 mit ihrer Plasmabehandlungskammer 60 als auch die Heizeinrichtung 100 sind in Umfangsrichtung der Trägereinrichtungen 12, 14 betrachtet, bevorzugt gleich verteilt, so etwa um 120° verteilt angeordnet.

Sofern weitere, in den Figuren nicht explizit dargestellte Prozessstationen vorgesehen sein sollten, ergibt sich natürlich eine hiervon abweichende wechselseitige Anordnung von Behandlungseinrichtung 50, Schleuse 30, 31 sowie Heizeinrichtung 100.

### Bezugszeichenliste

- 1: Drehachse
- 10: Transporteinrichtung
- 11: Vakuumbehandlungseinrichtung
- 12: Trägereinrichtung
- 14: Trägereinrichtung
- 16: Lager
- 18: Traggestell
- 20: Dichtrahmen
- 22: Dichtrahmen
- 24: Dichtrahmen
- 26: Dichtrahmen
- 28: Substrat
- 30: Schleuseneinrichtung
- 31: Schleuseneinrichtung
- 32: Schleusendeckel
- 34: Schleusendeckel
- 36: Be- und Entladeeinrichtung
- 37: Substrathalter
- 38: Be- und Entladeeinrichtung
- 39: Substrathalter
- 40: Betätigungsmechanismus
- 42: Druckplatte
- 44: Druckplatte
- 46: Außengehäuse
- 50: Behandlungseinheit
- 52: Innengehäuse
- 54: Durchgangsöffnung
- 56: Ringraum
- 58: Anregungsspule
- 60: Behandlungskammer
- 62: Auslass
- 64: Flansch
- 66: Druckplatte
- 68: Druckplatte
- 70: Druckstempel
- 72: Druckstempel
- 74: Prozessgasverteilung
- 76: Prozessgasverteilung
- 78: Innenraum
- 80: Druckplatte
- 82: Druckplatte
- 84: Druckstück
- 86: Absaugung
- 88: Absaugung
- 90: Trennelement
- 92: Trennelement
- 100: Heizeinrichtung
- 102: Heizmodul
- 104: Heizabschnitt
- 106: Heizabschnitt
- 108: Heizelement
- 110: Heizelement
- 112: Heizelement
- 114: Heizelement
- 116: Heizelement
- 118: Heizelement
- 120: Heizelement
- 122: Heizelement
- 130: Traggestell
- 132: Fortsatz
- 134: Feder
- 136: Feder

## Patentansprüche

1. Transporteinrichtung zum gleichzeitigen Transportieren von zumindest zwei in einer Vakuumbehandlungseinrichtung (11) zu behandelnden Substraten (28), mit zumindest zwei bezüglich einer gemeinsamen Achse (1) drehbar gelagerten und axial versetzt zueinander angeordneten Trägereinrichtungen (12, 14), an welchen zumindest jeweils ein zur Aufnahme zumindest eines Substrates (28) ausgebildeter Halterahmen (20, 22, 24, 26) angeordnet ist, wobei die Halterahmen (20, 22, 24, 26) durch eine Drehbewegung der Trägereinrichtungen (12, 14) um die Achse (1) in zueinander gegenüberliegende Wirkungsbereiche einer Behandlungseinheit (50) bringbar sind und wobei die Trägereinrichtungen (12, 14) einen solchen axialen Abstand zueinander aufweisen, dass die Behandlungseinheit (50) zwischen ihnen anordenbar ist.

2. Transporteinrichtung nach Anspruch 1, wobei die Halterahmen (20, 22, 24, 26) dazu ausgebildet sind, die jeweils daran anordenbaren Substrate (28) einander zugewandt in gegenüberliegende Wirkungsbereiche einer gemeinsamen, axial zwischen den Trägereinrichtungen (12, 14) anordenbaren Behandlungseinheit (50) zu überführen.

3. Transporteinrichtung nach Anspruch 1 oder 2, wobei die Halterahmen (20, 22, 24, 26) als Dichtrahmen ausgebildet sind, die an gegenüberliegenden Gehäuseabschnitten (52) einer Behandlungskammer (60) der Behandlungseinheit (50) abdichtend zur Anlage bringbar sind.

4. Transporteinrichtung nach einem der vorhergehenden Ansprüche , wobei zumindest einer der Halterahmen (20, 22, 24, 26) an seiner zugeordneten Trägereinrichtung (12, 14) axial verschiebbar angeordnet ist.

5. Transporteinrichtung nach einem der vorhergehenden Ansprüche, wobei zumindest eine der Trägereinrichtungen (12, 14) zumindest im Bereich des zumindest einen Halterahmens (20, 22, 24, 26) relativ zur Behandlungskammer (60) axial beweglich ausgebildet oder gelagert ist.

6. Transporteinrichtung nach einem der vorhergehenden Ansprüche, ferner mit einem die Trägereinrichtungen (12, 14) umgebenden Außengehäuse (46), an dessen in Axialrichtung (y) gegenüberliegenden Außenwänden jeweils eine Schleuseneinrichtung (30, 31) zur Aufnahme und Entnahme von Substraten (28) vorgesehen ist.

7. Transporteinrichtung nach einem der vorhergehenden Ansprüche, wobei die Trägereinrichtungen (12, 14) jeweils einen sich im Wesentlichen in einer Ebene (x, z) senkrecht zur Axialrichtung (y) erstreckenden Drehteller (130) mit daran entgegen einer Rückstellkraft auslenkbaren Halterahmen (20, 22, 24, 26) aufweist.

8. Transporteinrichtung nach einem der vorhergehenden Ansprüche, wobei die Trägereinrichtungen (12, 14) und/oder die Halterahmen (20, 22, 24, 26) im Wesentlichen vertikal und/oder die Achse (1) im wesentlichen horizontal ausgerichtet sind.

9. Transporteinrichtung nach einem der vorhergehenden Ansprüche 3 bis 8, wobei die im Bereich der Behandlungskammer (60) liegenden Dichtrahmen (20, 22, 24, 26) jeweils mittels zumindest einer am Dichtrahmen (20, 22, 24, 26) von außen zur Anlage gelangenden, in Axialrichtung (y) beweglichen Druckeinrichtung (66, 68; 80, 82) aufeinander zu gerichtet in eine mit der Behandlungskammer (60) abdichtende Anlagestellung überführbar sind.

10. Transporteinrichtung nach einem der vorhergehenden Ansprüche, wobei die Trägereinrichtungen (12, 14) mit ihren Halterahmen (20, 22, 24,26) in den Bereich einer Heizeinrichtung (100) verschwenkbar sind, welche jeweils zwei an gegenüberliegenden Abschnitten (104, 106) des Außengehäuses (46) nach innen gewandte Heizelemente (108, 114; 116, 122) und/oder zumindest ein zwischen den Trägereinrichtungen (12, 14) angeordnetes, nach außen gewandtes Heizelement (110, 112; 118, 120) aufweist.

11. Vakuumbehandlungseinrichtung mit einer Transporteinrichtung (10) nach einem der vorhergehenden Ansprüche und mit zumindest einer eine Behandlungskammer (60) aufweisenden Behandlungseinheit (50), die in Axialrichtung zwischen den zumindest zwei Trägereinrichtungen (12, 14) der Transporteinrichtung (10) angeordnet ist und die zur gleichzeitigen Behandlung von mittels der Transporteinrichtung (10) in zueinander gegenüberliegende Wirkungsbereiche der Behandlungseinheit (50) anordenbaren Substraten (28) ausgebildet ist.

12. Vakuumbehandlungseinrichtung nach Anspruch 11, wobei die Behandlungseinheit (50) zur Anregung eines zwischen zumindest zwei gegenüberliegend angeordneten Substraten (28) erzeugbaren Plasmas ausgebildet ist.

13. Vakuumbehandlungseinrichtung nach Anspruch 11 oder 12, wobei an einem Gehäuse (52) der Behandlungskammer (60) die als Dichtrahmen (20, 22, 24, 26) ausgebildeten Halterahmen der Transporteinrichtung (10) abdichtend zur Anlage bringbar sind.

14. Vakuumbehandlungseinrichtung nach Anspruch 11 bis 13, wobei die Behandlungseinheit (50) eine außerhalb der Behandlungskammer (60) angeordnete Anregungsspule (58) zur induktiven Anregung eines innerhalb der Behandlungskammer (60) erzeugbaren Plasmas aufweist.

15. Vakuumbehandlungseinrichtung nach einem der Ansprüche 11 bis 14, wobei die Behandlungseinheit (50) mit einem Innengehäuse (52) lösbar am Außengehäuse (46) anordenbar ist.

## Claims

1. Transporting apparatus for simultaneously transporting at least two substrates (28) which are to be treated in a vacuum-treatment apparatus (11), comprising at least two carrier apparatuses (12, 14), which are mounted rotatably with respect to a common axis (1) and are offset axially in relation to one another and on each of which is arranged at least one retaining frame (20, 22, 24, 26) designed to receive at least one substrate (28), wherein the retaining frames (20, 22, 24, 26) can be brought, by a rotary movement of the carrier apparatuses (12, 14) about the axis (1), into mutually opposed operative regions of a treatment unit (50), and wherein the carrier apparatuses (12, 14) are spaced apart axially from one another to such an extent that the treatment unit (50) can be arranged therebetween.

2. Transporting apparatus according to Claim 1, wherein the retaining frames (20, 22, 24, 26) are designed to transfer the mutually opposed substrates (28) that can be arranged on each of the retaining frames into opposed operative regions of a common treatment unit (50) that can be arranged axially between the carrier apparatuses (12, 14).

3. Transporting apparatus according to Claim 1 or 2, wherein the retaining frames (20, 22, 24, 26) are formed as sealing frames which can be brought into abutment in a sealing manner against opposed housing portions (52) of a treatment chamber (60) of the treatment unit (50).

4. Transporting apparatus according to one of the preceding claims, wherein at least one of the retaining frames (20, 22, 24, 26) is arranged axially displaceably on its associated carrier apparatus (12, 14) .

5. Transporting apparatus according to one of the preceding claims, wherein at least one of the carrier apparatuses (12, 14), at least in the region of the at least one retaining frame (20, 22, 24, 26), is formed or mounted so as to be axially movable relative to the treatment chamber (60) .

6. Transporting apparatus according to one of the preceding claims, further comprising an outer housing (46) surrounding the carrier apparatuses (12, 14), a lock apparatus (30, 31) for receiving and removing substrates (28) being provided on each of the outer walls of said outer housing that are arranged opposite in the axial direction (y).

7. Transporting apparatus according to one of the preceding claims, wherein the carrier apparatuses (12, 14) each comprise a rotary table (130) extending substantially in a plane (x, z) perpendicular to the axial direction (y) and having retaining frames (20, 22, 24, 26) thereon deflectable against a restoring force.

8. Transporting apparatus according to one of the preceding claims, wherein the carrier apparatuses (12, 14) and/or the retaining frames (20, 22, 24, 26) are oriented substantially vertically and/or the axes (1) are oriented substantially horizontally.

9. Transporting apparatus according to one of preceding claims 3 to 8, wherein each of the sealing frames (20, 22, 24, 26) arranged in the region of the treatment chamber (60) can be transferred, facing one another, into a sealing abutment position with the treatment chamber (60) by means of at least one press apparatus (66, 68; 80, 82) coming into abutment externally with the sealing frame (20, 22, 24, 26) and movable in the axial direction (y).

10. Transporting apparatus according to one of the preceding claims, wherein the carrier apparatuses (12, 14) with their retaining frames (20, 22, 24, 26) can be pivoted into the region of a heating apparatus (100), which comprises in each case two inwardly facing heating elements (108, 114; 116, 122) on opposed portions (104, 106) of the outer housing (46) and/or at least one outwardly facing heating element (110, 112; 118, 120) arranged between the carrier apparatuses (12, 14).

11. Vacuum-treatment apparatus comprising a transporting apparatus (10) according to one of the preceding claims and comprising at least one treatment unit (50), which comprises a treatment chamber (60), is arranged between the at least two carrier apparatuses (12, 14) of the transporting apparatus (10) in the axial direction, and which is designed to simultaneously treat substrates (28) which can be arranged by means of the transporting apparatus (10) in mutually opposed operative regions of the treatment unit (50).

12. Vacuum-treatment apparatus according to Claim 11, wherein the treatment unit (50) is designed to excite a plasma which can be generated between at least two oppositely arranged substrates (28).

13. Vacuum-treatment apparatus according to Claim 11 or 12, wherein the retaining frames, of the transporting apparatus (10), formed as sealing frames (20, 22, 24, 26), can be brought into abutment in a sealing manner against a housing (52) of the treatment chamber (60).

14. Vacuum-treatment apparatus according to Claim 11 to 13, wherein the treatment unit (50) comprises an excitation coil (58), which is arranged outside the treatment chamber (60), in order to inductively excite a plasma which can be generated within the treatment chamber (60).

15. Vacuum-treatment apparatus according to one of Claims 11 to 14, wherein the treatment unit (50) with an inner housing (52) can be arranged detachably on the outer housing (46).

## Revendications

1. Dispositif de transport destiné à transporter simultanément au moins deux substrats (28) devant être traités dans un dispositif de traitement sous vide (11), comprenant au moins deux dispositifs de support (12, 14) supportés de manière à pouvoir tourner par rapport à un axe commun (1) et disposés de manière décalée axialement l'un par rapport à l'autre, au niveau desquels est disposé au moins à chaque fois un cadre de retenue (20, 22, 24, 26) réalisé pour recevoir au moins un substrat (28), les cadres de retenue (20, 22, 24, 26) pouvant être amenés par un mouvement de rotation des dispositifs de support (12, 14) autour de l'axe (1) dans des zones d'action mutuellement opposées d'une unité de traitement (50) et les dispositifs de support (12, 14) présentant une distance axiale l'un de l'autre telle que l'unité de traitement (50) puisse être disposée entre eux.

2. Dispositif de transport selon la revendication 1, dans lequel les cadres de retenue (20, 22, 24, 26) sont réalisés de manière à transférer les substrats (28) pouvant être disposés à chaque fois sur ceux-ci de manière tournée l'un vers l'autre dans des zones d'action opposées d'une unité de traitement (50) commune, pouvant être disposée axialement entre les dispositifs de support (12, 14).

3. Dispositif de transport selon la revendication 1 ou 2, dans lequel les cadres de retenue (20, 22, 24, 26) sont réalisés sous forme de cadres d'étanchéité qui peuvent être amenés en appui de manière hermétique contre des portions de boîtier opposées (52) d'une chambre de traitement (60) de l'unité de traitement (50).

4. Dispositif de transport selon l'une quelconque des revendications précédentes, dans lequel au moins l'un des cadres de retenue (20, 22, 24, 26) est disposé de manière déplaçable axialement au niveau de son dispositif de support associé (12, 14).

5. Dispositif de transport selon l'une quelconque des revendications précédentes, dans lequel au moins l'un des dispositifs de support (12, 14) est réalisé ou supporté de manière déplaçable axialement par rapport à la chambre de traitement (60) au moins dans la région de l'au moins un cadre de retenue (20, 22, 24, 26).

6. Dispositif de transport selon l'une quelconque des revendications précédentes, comprenant en outre un boîtier extérieur (46) entourant les dispositifs de support (12, 14), au niveau des parois extérieures opposées dans la direction axiale (y) duquel est à chaque fois prévu un dispositif de sas (30, 31) pour recevoir et prélever des substrats (28).

7. Dispositif de transport selon l'une quelconque des revendications précédentes, dans lequel les dispositifs de support (12, 14) présentent à chaque fois un plateau tournant (130) s'étendant essentiellement dans un plan (x, z) perpendiculaire à la direction axiale (y) avec, sur ceux-ci, des cadres de retenue (20, 22, 24, 26) pouvant être déviés à l'encontre d'une force de rappel.

8. Dispositif de transport selon l'une quelconque des revendications précédentes, dans lequel les dispositifs de support (12, 14) et/ou les cadres de retenue (20, 22, 24, 26) sont orientés essentiellement verticalement et/ou l'axe (1) est orienté essentiellement horizontalement.

9. Dispositif de transport selon l'une quelconque des revendications précédentes 3 à 8, dans lequel les cadres d'étanchéité (20, 22, 24, 26) situés dans la région de la chambre de traitement (60) peuvent être transférés de manière orientée l'un vers l'autre dans une position d'appui réalisant l'étanchéité avec la chambre de traitement (60) à chaque fois au moyen d'au moins un dispositif de pression (66, 68 ; 80, 82) déplaçable dans la direction axiale (y), parvenant en appui depuis l'extérieur contre le cadre d'étanchéité (20, 22, 24, 26).

10. Dispositif de transport selon l'une quelconque des revendications précédentes, dans lequel les dispositifs de support (12, 14) peuvent être pivotés avec leurs cadres de retenue (20, 22, 24, 26) dans la région d'un dispositif de chauffage (100) qui présente à chaque fois deux éléments chauffants (108, 114 ; 116, 122) tournés vers l'intérieur au niveau de portions opposées (104, 106) du boîtier extérieur (46), et/ou au moins un élément chauffant (110, 112 ; 118, 120) tourné vers l'extérieur, disposé entre les dispositifs de support (12, 14).

11. Dispositif de traitement sous vide comprenant un dispositif de transport (10) selon l'une quelconque des revendications précédentes, et comprenant au moins une unité de traitement (50) présentant une chambre de traitement (60), qui est disposée dans la direction axiale entre les au moins deux dispositifs de support (12, 14) du dispositif de transport (10) et qui est réalisée pour traiter simultanément des substrats (28) pouvant être disposés au moyen du dispositif de transport (10) dans des zones d'action mutuellement opposées de l'unité de traitement (50).

12. Dispositif de traitement sous vide selon la revendication 11, dans lequel l'unité de traitement (50) est réalisée pour exciter un plasma pouvant être généré entre au moins deux substrats (28) disposés à l'opposé l'un de l'autre.

13. Dispositif de traitement sous vide selon la revendication 11 ou 12, dans lequel les cadres de retenue du dispositif de transport (10) réalisés sous forme de cadres d'étanchéité (20, 22, 24, 26) peuvent être amenés en appui de manière hermétique contre un boîtier (52) de la chambre de traitement (60) .

14. Dispositif de traitement sous vide selon les revendications 11 à 13, dans lequel l'unité de traitement (50) présente une bobine d'excitation (58) disposée à l'extérieur de la chambre de traitement (60) pour l'excitation par induction d'un plasma pouvant être généré à l'intérieur de la chambre de traitement (60).

15. Dispositif de traitement sous vide selon l'une quelconque des revendications 11 à 14, dans lequel l'unité de traitement (50) peut être disposée avec un boîtier intérieur (52) de manière amovible sur le boîtier extérieur (46).
